Europäisches Patentamt

European Patent Office

Office européen des brevets

(19)

(11) Veröffentlichungsnummer: **0 095 744**
A1

(12) # EUROPÄISCHE PATENTANMELDUNG

(21) Anmeldenummer: 83105242.8

(22) Anmeldetag: 26.05.83

(51) Int. Cl.³: **H 05 K 9/00**, H 05 K 7/20

(30) Priorität: 28.05.82 DE 3220287

(43) Veröffentlichungstag der Anmeldung: **07.12.83**
**Patentblatt 83/49**

(84) Benannte Vertragsstaaten: **DE FR GB IT**

(71) Anmelder: **SIEMENS AKTIENGESELLSCHAFT, Berlin**
**und München Wittelsbacherplatz 2,**
**D-8000 München 2 (DE)**

(72) Erfinder: **Schulz, Hans-Werner, Dipl.-Ing., Am Höllberg 9,**
**D-8411 Wenzenbach (DE)**

(54) **Belüftungseinsatz für geschirmte Kabinen und Raumabschirmungen.**

(57) Belüftungseinsatz für geschirmte Kabinen und Raumabschirmungen mit einer zu einem Einsatz zusammengesetzten Vielzahl kleiner Hohlleiter (19), durch die das Innere der Kabinen und Räume in luftdurchlässiger Verbindung mit dem Außenraum steht, wobei der Einsatz zueinander parallele und beabstandete Bleche (11, 14) mit zueinander versetzten Schlitzen (12, 15) aufweist und jeweils zwischen benachbarten Blechen Hohlleiter (19) angeordnet sind.

EP 0 095 744 A1

SIEMENS AKTIENGESELLSCHAFT     Unser Zeichen
Berlin und München     VPA

**82 P 1 4 2 2 E**

## Belüftungseinsatz für geschirmte Kabinen und Raumabschirmungen

Die Erfindung betrifft einen Belüftungseinsatz für geschirmte Kabinen und Raumabschirmungen, mit einer zu einem Einsatz zusammengesetzten Vielzahl kleiner Hohlleiter, durch die das Innere der Kabinen und Räume in luftdurchlässiger Verbindung mit dem Außenraum steht.

Die Belüftungseinsätze oder Fenster, die auch als Wabenkamineinsätze bezeichnet werden, bestehen aus einer Vielzahl von nebeneinander angeordneten Hohlleitern, die unterhalb ihrer Grenzfrequenz, d.h. der Frequenz bei welcher der Hohlleiter leitet, dämpfend wirken. Durch die geometrischen Abmessungen der Hohlleiter, die ggf. zusätzliche Perforation der Hohlleiterwände und durch die Größe des daraus zusammengesetzten Einsatzes wird eine genügende Be- und Entlüftung von geschirmten Räumen gewährleistet.

Bekannte Wabenkamineinsätze, die ausreichenden Tageslichteinfall bei gleichzeitig genügender Be- und Entlüftung ermöglichen, sind in den Fig. 1 bis 4 dargestellt. Die Fig. 1 zeigt dabei einen für eine Grenzfrequenz von ca. 1 GHz wirksamen Wabenkamineinsatz 1, der aus nebeneinanderliegenden, nahezu rechteckförmigen Hohlleiterstücken besteht, die durch Punktschweißen und Tauchverzinnen miteinander verbunden sind. Die Einsätze 2, 3 nach Fig. 2 und 3, deren Hohlleiter im Querschnitt sechseckförmig bzw. quadratisch ausgebildet sind, sind für eine Grenzfrequenz von ca. 10 GHz ge-

Kra 1 vi/21.05.1982

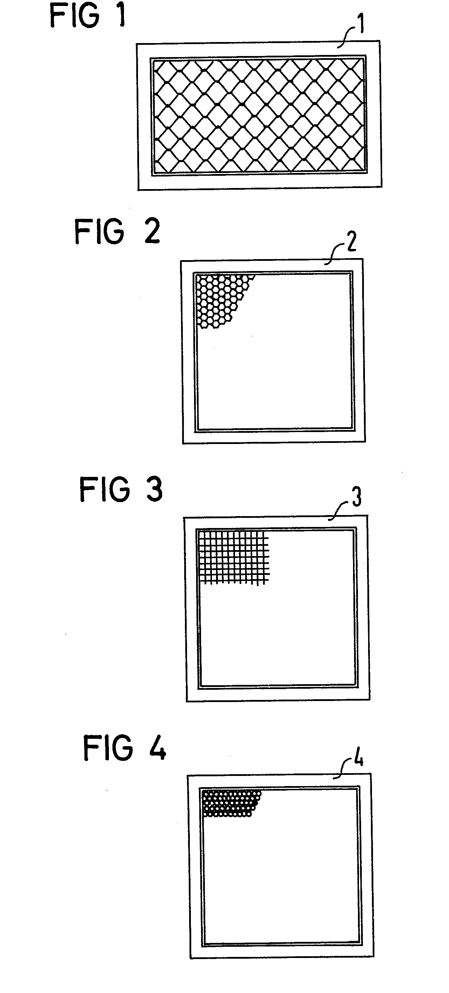

eignet. Der Wabenkamineinsatz 4 nach Fig. 4 wird durch nebeneinanderliegende, miteinander verlötete, röhrchenförmige Hohlleiter gebildet, deren Grenzfrequenz 35 GHz beträgt.

Allen gezeigten bekannten Wabenkamineinsätzen ist gemeinsam, daß sie nur mit erheblichem Aufwand herstellbar sind. Zwar sind Wabenkamineinsätze nach Fig. 1 aufgrund des großen Hohlleiterdurchmessers mechanisch gut bearbeitbar, jedoch treten beim Zusammenfügen und Verzinnen der Blechteile bzw. Röhrchen, insbesondere der in Fig. 2 bis 4 dargestellten Art, erhebliche Schwierigkeiten auf. Zum einen ist bereits das Zusammenfügen der Einzelteile wirtschaftlich kaum vertretbar; zum anderen erleiden die beim Verzinnen in die Zinnbäder eingetauchten Wabenkamineinsätze, bedingt durch die dabei auftretende Wärme, merkliche Dehnungen, was beim Erkalten insbesondere bei dem Wabenkamineinsatz nach Fig. 4 zu Rissen führen kann.

Der vorliegenden Erfindung liegt die Aufgabe zugrunde, einen Belüftungseinsatz für geschirmte Kabinen und Raumabschirmungen der eingangs genannten Art zu schaffen, der insbesondere für hohe und höchste Frequenzen geeignet ist, einfach herstellbar ist und hinsichtlich seiner Dämpfungseigenschaften den derzeit gestellten Forderungen genügt.

Bei einem Belüftungseinsatz gemäß Oberbegriff des Patentanspruchs 1 sieht die Erfindung zur Lösung der gestellten Aufgabe vor, daß der Einsatz zueinander parallele und beabstandete Bleche mit zueinander versetzten Schlitzen aufweist und daß jeweils zwischen benachbarten Blechen Hohlleiter angeordnet sind.

Bei einem bevorzugten Ausführungsbeispiel sind zwischen den Blechen Blechstreifen angeordnet, die zur Schaffung einer Vielzahl kleiner Hohlleiter ein fortlaufend rechteckförmiges Profil besitzen, wobei die Blechstreifen mit ihren stegförmigen, an die benachbarten Bleche anstoßenden Bereichen mit den Blechen galvanisch verbunden sind.

Ein anderer, gleichfalls nur mit geringem Aufwand herstellbarer Belüftungseinsatz sieht zwischen den Blechen Blechstreifen mit wellenförmigem Profil vor, wobei die Blechstreifen jeweils in den Bereichen ihrer Wellenmaxima, d.h. in ihren an die benachbarten Bleche bzw. Wände anstoßenden Teilen mit den Blechen galvanisch verbunden sind.

Üblich, jedoch nicht unbedingt erforderlich, sind die Blechstreifen und die Schlitze der Bleche - jeweils betrachtet in Längsrichtung - parallel zueinander ausgerichtet, derart, daß die Hohlleiter senkrecht zu den Schlitzen angeordnet sind.

Die Erfindung wird nachstehend anhand von Ausführungsbeispielen näher erläutert. Es zeigt:

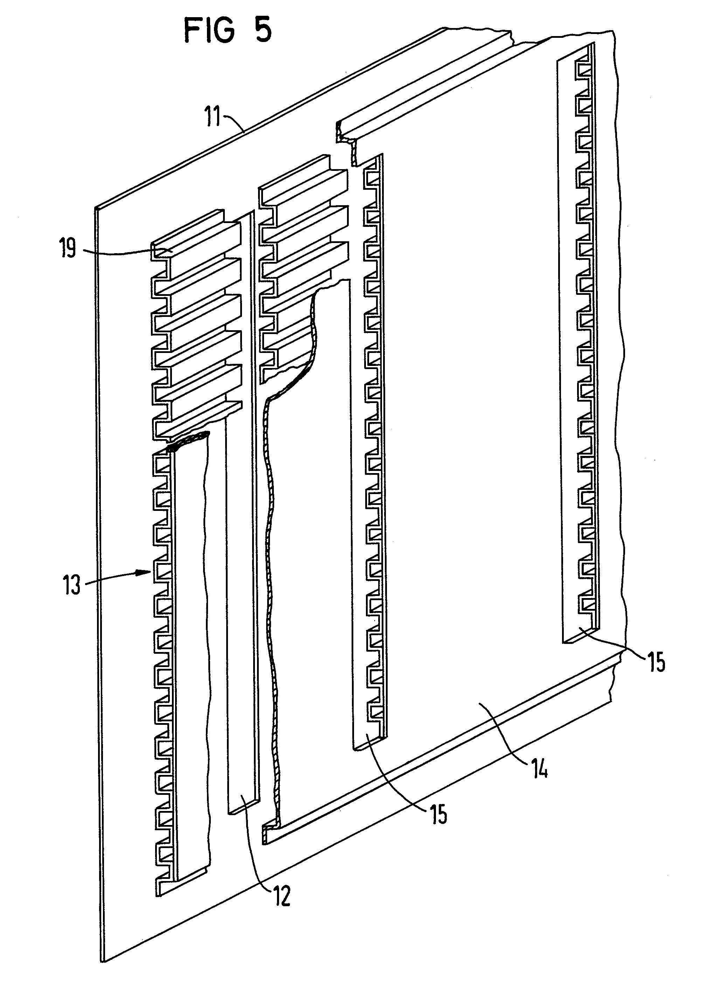

Fig. 5 in gebrochener, schematischer und perspektivischer Ansicht ein erstes Ausführungsbeispiel eines Belüftungseinsatzes nach der Erfindung,

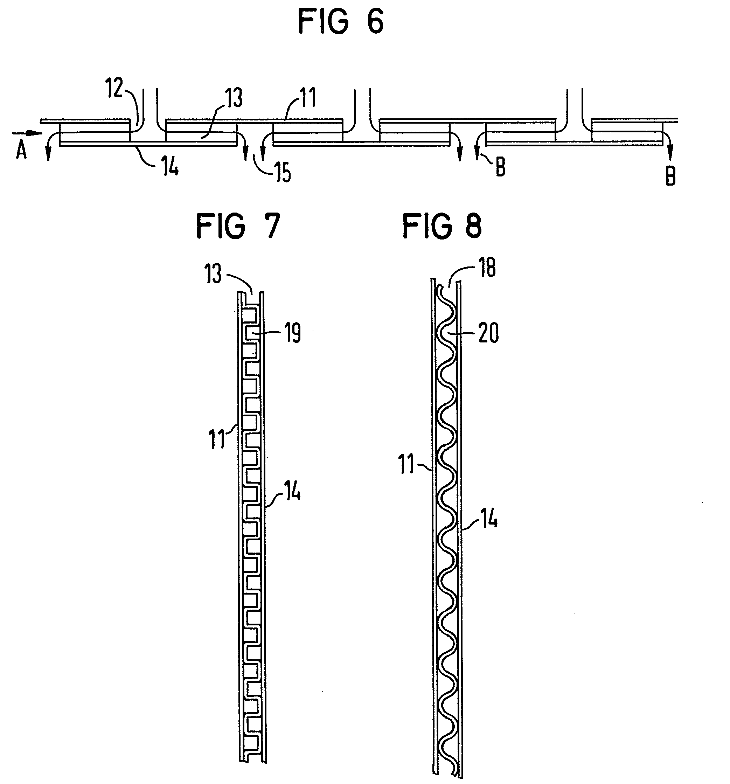

Fig. 6 eine Draufsicht auf den Belüftungseinsatz nach Fig. 5,

Fig. 7 den Belüftungseinsatz nach Fig. 5, 6, betrachtet in Pfeilrichtung A.

Fig. 8 in der Ansicht nach Fig. 7 ein zweites Ausführungsbeispiel für die Ausbildung des zwischen
den Blechen angeordneten Blechstreifens.

Der Belüftungseinsatz nach Fig. 5 besitzt ein Blech 11,
in das Schlitze 12 eingestanzt sind. Zwischen den
Schlitzen 12 sind Blechstreifen 13 angeordnet, die zur
Schaffung einer Vielzahl kleiner Hohlleiter 19 ein
fortlaufend rechteckförmiges Profil aufweisen. Die
Blechstreifen 13 sind dabei mit ihren zum Blech 11
gekehrten stegförmigen Teilen auf das Blech 11 aufgelötet oder aufgeschweißt. Auf die hierzu abgekehrten
stegförmigen Teile der Blechstreifen 13 ist ein zweites
vorgeformtes Blech 14 aufgelötet bzw. aufgeschweißt,
das zu den Schlitzen 12 versetzte Schlitze 15 hat.

Die Wirkungsweise dieses Belüftungseinsatzes ist aus
Fig. 6 ersichtlich. Die durch entsprechende elektrische
Einrichtungen im Kabineninneren erzeugte Welle wird im
Bereich der Schlitze 12 um 90 Grad - siehe Pfeilrichtung
B - in Richtung zu den Schlitzen 15 umgelenkt und durchläuft dabei die Hohlleiter 19. Für diesen Belüftungseinsatz gelten selbstverständlich gleichfalls die bekannten grundsätzlichen Berechnungsformeln hinsichtlich
der Hohlleiter-Sperrwirkung.

Der in Fig. 5 bis 7 dargestellte Belüftungseinsatz ist
verhältnismäßig einfach herstellbar. Durch Knicke und
Falze können Versteifungen in die tragenden Bleche 11,
14 eingearbeitet sein, so daß auch vergleichbar große
Belüftungseinsätze geschaffen werden können. Anstelle
der rechteckförmigen Formgebung der Zwischenbleche bzw.
Blechstreifen 13 sind beispielsweise auch Blechstreifen 18 nach Fig. 8 geeignet, welche zur Schaffung einer Vielzahl kleiner Hohlleiter 20 wellenförmiges Profil
besitzen.


4 Patentansprüche

0095744

82 P 1 4 2 2 E

Patentansprüche

1. Belüftungseinsatz für geschirmte Kabinen und Raumabschirmungen mit einer zu einem Einsatz zusammengesetzten Vielzahl kleiner Hohlleiter, durch die das Innere der Kabinen und Räume in luftdurchlässiger Verbindung mit dem Außenraum steht, d a d u r c h  g e k e n n z e i c h n e t , daß der Einsatz zueinander parallele und beabstandete Bleche (11,14) mit zueinander versetzten Schlitzen (12,15) aufweist, und daß jeweils zwischen benachbarten Blechen Hohlleiter (19,20) angeordnet sind.

2. Belüftungseinsatz nach Anspruch 1, d a d u r c h  g e k e n n z e i c h n e t , daß zwischen den Blechen (11,14) Blechstreifen (13) angeordnet sind, die zur Schaffung einer Vielzahl kleiner Hohlleiter (19) ein fortlaufend rechteckförmiges Profil aufweisen, und daß die Blechstreifen mit ihren stegförmigen Teilen mit den Blechen (11,14) galvanisch verbunden sind.

3. Belüftungseinsatz nach Anspruch 1, d a d u r c h  g e k e n n z e i c h n e t , daß zwischen den Blechen (11,14) Blechstreifen (13) angeordnet sind, die zur Schaffung einer Vielzahl kleiner Hohlleiter (20) ein wellenförmiges Profil aufweisen, und daß die Blechstreifen jeweils in den Bereichen ihrer Wellenmaxima mit den Blechen (11,14) galvanisch verbunden sind.

0095744

4. Belüftungseinsatz nach Anspruch 1 bis 3,
   d a d u r c h  g e k e n n z e i c h n e t ,
   daß die Blechstreifen (13,13) und die Schlitze
   (12,15) der Bleche (11,14) - jeweils betrachtet
   in Längsrichtung - parallel zueinander ausgerichtet sind, derart, daß die Hohlleiter (19,20)
   senkrecht zu den Schlitzen angeordnet sind.

FIG 1

FIG 2

FIG 3

FIG 4

FIG 5

FIG 6

FIG 7    FIG 8

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | DE-A-2 652 813 (BBC)<br>* Ansprüche 1-5; Seite 6, Zeilen 4-25; Seite 13, Zeilen 3-23; Figuren 3, 4 * | 1 | H 05 K 9/00<br>H 05 K 7/20 |
| | --- | | |
| A | DE-A-2 357 892 (SIEMENS)<br>* Seite 2, Zeilen 1-27; Seite 4, Zeilen 5-15; Seite 7, Zeile 26 - Seite 8, Zeile 19; Figur 8 * | 1-3 | |
| | --- | | |
| A | US-A-3 584 134 (NICHOLS et al.)<br>* Spalte 3, Zeilen 10-52; Figuren 1, 2 * | | |
| | --- | | |
| A | EP-A-0 042 369 (SIEMENS)<br>* Seite 1, Zeile 1 - Seite 2, Zeile 15; Figuren 1-3 * | | |
| | ----- | | |

**RECHERCHIERTE SACHGEBIETE (Int. Cl. ³)**

G 12 B 17/00
H 05 K 7/20
H 05 K 9/00

Der vorliegende Recherchenbericht wurde für alle Patentansprüche erstellt.

| Recherchenort<br>BERLIN | Abschlußdatum der Recherche<br>12-08-1983 | Prüfer<br>HAHN G |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82